# EUROPEAN PATENT APPLICATION

(11) **EP 2 876 690 A1**
(43) Date of publication of application: **27.05.2015**
(21) Application number: 13820393.0
(22) Date of filing: 19.07.2013
(51) Int. Cl.: H01L 31/04, H01L 21/316

(54) **PASSIVATION FILM, COATING MATERIAL, SOLAR-CELL ELEMENT, AND SILICON SUBSTRATE WITH PASSIVATION FILM ATTACHED THERETO**

(30) Priority: 19.07.2012 JP 2012160336
(71) Applicant: Hitachi Chemical Company, Ltd., Chiyoda-ku Tokyo 100-6606 (JP)
(72) Inventor: HATTORI, Takashi, Kokubunji-shi Tokyo 185-8601 (JP); MATSUMURA, Mieko, Kokubunji-shi Tokyo 185-8601 (JP); WATANABE, Keiji, Kokubunji-shi Tokyo 185-8601 (JP); MORISHITA, Masatoshi, Kokubunji-shi Tokyo 185-8601 (JP); HAMAMURA, Hirotaka, Kokubunji-shi Tokyo 185-8601 (JP)
(74) Representative: Hoffmann Eitle
(86) International application number: PCT/JP2013/069707
(87) International publication number: WO 2014/014117

(57) **Abstract**

A passivation film includes aluminum oxide and niobium oxide, and the passivation film is used in a photovoltaic cell element having a silicon substrate. A photovoltaic cell element includes: a p-type silicon substrate 1 that comprises monocrystalline silicon or polycrystalline silicon; an n-type impurity diffusion layer 2 that is formed on a light receiving surface of the silicon substrate 1; a first electrode 5 that is formed on the n-type impurity diffusion layer 2; a second electrode 6 that is formed on the back surface of the silicon substrate 1; a passivation film 7 that is formed on the back surface of the silicon substrate 1, the passivation film 7 having plural openings OA and including aluminum oxide and niobium oxide. The second electrode 6 is electrically connected to the back surface of the silicon substrate 1 through the plural openings OA.

## Description

### [Technical Field]

The present invention relates to a passivation film, a coating material, a photovoltaic cell element, and a semiconductor substrate having a passivation film.

### [Background Art]

A photovoltaic cell is a photoelectric conversion element that converts energy from sunlight into electrical energy, which is expected to become yet more widely used in the future as a pollution-free and limitless renewable energy.

A photovoltaic cell usually includes a p-type semiconductor and an n-type semiconductor, and produces an electron-hole pair within a semiconductor by absorbing energy from sunlight. A generated electron transfers to an n-type semiconductor and a generated hole transfers to a p-type semiconductor, and these are then collected at an electrode, thereby becoming externally available as electrical energy.

However, it is important that the efficiency of a photovoltaic cell element is improved so that energy from sunlight is converted into electrical energy so as to output as much electrical energy as possible. In order to improve the efficiency of a photovoltaic cell element, it is important that as many electron-hole pairs are generated as possible. In addition, it is also important that generated charge is externally output while reducing charge loss.

Charge loss arises due to a number of causes. In particular, charge loss arises when charge is extinguished due to recombination of a generated electron and hole.

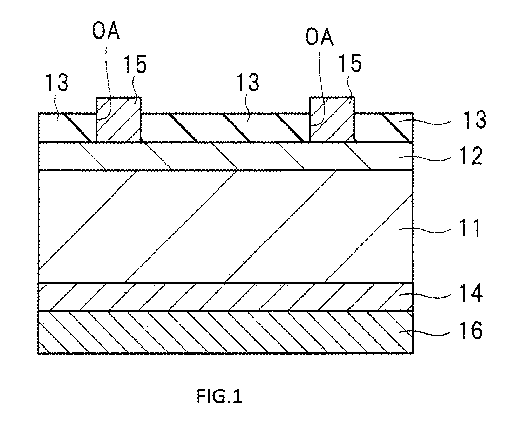

In a currently mainstream silicon photovoltaic cell element, as shown in Figure 1, using a p-type silicon substrate 11 having a pyramid-like structure for the purpose of anti-reflection that is referred to as a texture, n-layer 12 is formed on a light receiving surface and p⁺-layer 14 is formed on a back surface. In addition, on a light receiving surface, a silicon nitride (SiN) film 13 is provided as a passivation film of the light receiving surface, and a silver collector electrode referred to as a finger electrode 15 is formed. On a back surface, aluminum electrode 16, which suppresses light transmission, is formed on the entire surface.

n-layer 12 is generally formed by diffusing gas-phase or solid-phase phosphorus into silicon substrate 11. p⁺-layer 14 on a back surface is formed by thermal treatment at 700°C or higher on a back surface at a contacting portion of the aluminum and the silicon substrate 11, when forming aluminum electrode 16. In this process, aluminum diffuses into silicon substrate 11 to generate an alloy, thereby forming p⁺-layer 14.

At an interface between p-type silicon substrate 11 and p⁺-layer 14, an electric field is generated that derives from a potential difference. The electric field generated from p⁺-layer 14 is generated mainly within p-type silicon substrate 11. Due to the electric field, the electrons, among electrons and holes that are transferred toward a back surface, are reflected back toward the inside of p-type silicon substrate 11, while the holes selectively go through p⁺-layer 14. That is, in this mechanism, the electrons are driven out, thereby bringing about an effect of reducing recombination of holes and electrons at an interface of a back surface of a photovoltaic cell element. This kind of conventional photovoltaic cell element, in which an aluminum alloy is provided on a back surface, is widely used as a configuration that is suitable for production because production thereof is comparatively simple.

However, in the conventional photovoltaic cell element having p⁺-layer 14 on a back surface, the interface between p⁺-layer 14 and electrode 16 is not subjected to any inactivation treatment to reduce the speed of interface recombination. Moreover, since aluminum becomes a recombination center, at which aluminum is doped at a high concentration in p⁺-layer 14, the existing density of the recombination center is high, whereby p⁺-layer 14 is inferior in quality to other areas.

In order to solve this problem, a back passivation type photovoltaic cell element has been developed with the aim of replacing the conventional photovoltaic cell element. In contrast to the conventional photovoltaic cell element, a back passivation type photovoltaic cell element can terminate a dangling bond, which naturally exists at an interface between a silicon substrate and a passivation film and causes recombination, by covering a back surface of a photovoltaic cell element with a passivation film. That is, in a back passivation type photovoltaic cell element, the density of the recombination center is reduced to suppress recombination of carriers (i.e., holes and electrons), rather than by reducing the speed of recombination of carriers, by the electric field generated at a p/p⁺ interface. Further, when a passivation film reduces the speed of recombination of carriers by means of an electric field generated from fixed charge in the passivation film to reduce carrier density, the passivation film is referred to as a passivation film having an electrical field effect, In particular, when the density of the recombination center on a back surface is large, a passivation film having an electrical field effect is advantageous because it keeps carriers away from the recombination center by means of the electric field.

As a passivation film having an electrical field effect, an aluminum oxide film formed by ALD-CVD (Atomic Layer Deposition-Chemical Vapor Deposition) is known. In order to reduce the costs of forming a film, a technique that uses a coating film of a sol gel of aluminum oxide as a passivation film is known (see, for example, International Publications WO 2008/137174, WO 2009/052227 and WO 2010/044445 and B. Hoex, J. Schmidt, P. Pohl, M. C. M. van de Sanden and W. M. M. Kesseles, "Silicon surface passivation by atomic layer deposited Al2O3", J Appl. Phys, 104, p.44903(2008)).

However, there has been the problem that costs are difficult to reduce, since high throughput is not obtained because the ALD method is slow in deposition rate. Moreover, a through hole is needed for electrical contact with an electrode on a back surface after forming an aluminum oxide film. Therefore, some kind of patterning technique is demanded.

In order to reduce the costs of forming a film, a technique that uses a coating film of a sol gel of aluminum oxide as a passivation film is known.

### SUMMARY OF INVENTION

### [Technical Problem]

Since a coating film of a sol gel of aluminum oxide is unstable in terms of negative fixed charge, in a CV (Capacitance-Voltage) method, negative fixed charge tends to be obtained.

In view of these problems, a first problem to be solved by the present invention is to provide a passivation film having a negative fixed charge at low cost by prolonging the carrier lifetime of a silicon substrate. A second problem to be solved by the present invention is to provide a coating material to enable formation of the passivation layer. A third problem to be solved by the present invention is to provide a photovoltaic cell element having excellent efficiency using the passivation film at low cost. A fourth problem to be solved by the present invention is to provide a semiconductor substrate having a passivation film, which has a negative fixed charge at low cost by prolonging the carrier lifetime of a silicon substrate.

These problems, other problems, and new features will be revealed in the description of the present specification and the drawings.

### [Solution to Problems]

A passivation films according to the present invention for solving the above-mentioned first problem are as follows.
<1> A passivation film comprising aluminum oxide and niobium oxide, in which the passivation film is used in a photovoltaic cell element having a silicon substrate.
   By including aluminum oxide and niobium oxide, the carrier lifetime of a silicon substrate can be prolonged and a silicon substrate can have a negative fixed charge. Although the reason that the carrier lifetime is prolonged is not clear, one of the reasons is thought to be that a dangling bond is terminated.
<2> The passivation film according to <1>, in which a mass ratio of the niobium oxide to the aluminum oxide (niobium oxide/aluminum oxide) is from 30/70 to 90/10.
   This enables to have a large stable negative fixed charge.
<3> The passivation film according to <1> or <2>, in which a total content of the niobium oxide and the aluminum oxide is 90% by mass or more.
<4> The passivation film according to any one of <1> to <3>, further including an organic component.
<5> The passivation film according to any one of <1> to <4>, which is a thermally-treated product of a coating material including an aluminum oxide precursor and a niobium oxide precursor.

A coating material according to the present invention for solving the above-mentioned second problem is as follows.
<6> A coating material including an aluminum oxide precursor and a niobium oxide precursor, in which the coating material is used for formation of a passivation film of a photovoltaic cell element having a silicon substrate.

A photovoltaic cell elements according to the present invention for solving the above-mentioned third problem are as follows.
<7> A photovoltaic cell element, including:
   a p-type silicon substrate that includes monocrystalline silicon or polycrystalline silicon, and that has a light receiving surface and a back surface at an opposite side from the light receiving surface;
   an n-type impurity diffusion layer that is formed on the light receiving surface of the silicon substrate;
   a first electrode that is formed on a surface of the n-type impurity diffusion layer of the light receiving surface of the silicon substrate;
   a passivation film that is formed on the back surface of the silicon substrate, the passivation film having plural openings and including aluminum oxide and niobium oxide; and
   a second electrode that is electrically connected to the back surface of the silicon substrate through the plural openings.
<8> A photovoltaic cell element, including:
   a p-type silicon substrate that includes monocrystalline silicon or polycrystalline silicon, and that has a light receiving surface and a back surface at an opposite side from the light receiving surface;
   an n-type impurity diffusion layer that is formed on the light receiving surface of the silicon substrate;
   a first electrode that is formed on a surface of the n-type impurity diffusion layer of the light receiving surface of the silicon substrate;
   a p-type impurity diffusion layer that is formed on an entire or partial back surface of the silicon substrate, and that is doped with an impurity at a higher concentration than the silicon substrate;
   a passivation film that is formed on the back surface of the silicon substrate, the passivation film having plural openings and including aluminum oxide and niobium oxide; and
   a second electrode that is electrically connected to the p-type impurity diffusion layer of the back surface of the silicon substrate through the plural openings.
<9> A photovoltaic cell element, including:
   an n-type silicon substrate that includes monocrystalline silicon or polycrystalline silicon and has a light receiving surface and a back surface at an opposite side from the light receiving surface;
   a p-type impurity diffusion layer that is formed on the light receiving surface of the silicon substrate;
   a second electrode that is formed on the back surface of the silicon substrate;
   a passivation film that is formed on the light receiving surface of the silicon substrate, the passivation film having plural openings and including aluminum oxide and niobium oxide; and
   a first electrode that is formed on the p-type impurity diffusion layer of the light receiving surface of the silicon substrate, and that forms an electrical connection with a surface at the light receiving side of the silicon substrate.
<10> The photovoltaic cell element according to any one of <7> to <9>, in which a mass ratio of niobium oxide to aluminum oxide (niobium oxide/aluminum oxide) in the passivation film is from 30/70 to 90/10.
<11> The photovoltaic cell element according to any one of <7> to <10>, in which a total content of the niobium oxide and the aluminum oxide in the passivation film is 90% by mass or more.
A silicon substrate having a passivation film according to the present invention for solving the above-mentioned fourth problem is as follows.
<12> A silicon substrate having a passivation film, including:
   a silicon substrate; and
   the passivation film according to any one of <1> to <5>, which is provided on an entire or partial surface of the silicon substrate.

### [Advantageous Effects of Invention]

According to the invention, a passivation film that can extend the carrier lifetime of a silicon substrate and has a negative fixed charge can be attained at low cost. Further, a coating material for forming the passivation film can be provided. Further, a photovoltaic cell element that has the passivation film and exhibits a high efficiency can be attained at low cost. Further, a silicon substrate having a passivation film that extends carrier lifetime and has a negative fixed charge can be attained at low cost.

### BRIEF DESCRIPTION OF DRAWINGS

Figure 1 is a cross sectional view showing a structure of a conventional double-sided electrode type photovoltaic cell element.
Figure 2 is a cross sectional view of a first constitutional example of a photovoltaic cell element having a passivation film at a back surface.
Figure 3 is a cross sectional view of a second constitutional example of a photovoltaic cell element having a passivation film at a back surface.
Figure 4 is a cross sectional view of a third constitutional example of a photovoltaic cell element having a passivation film at a back surface.
Figure 5 is a cross sectional view of a fourth constitutional example of a photovoltaic cell element having a passivation film at a back surface.
Figure 6 is a cross sectional view of another constitutional example of a photovoltaic cell element having a passivation film at a light receiving surface.

### DESCRIPTION OF EMBODIMENTS

In the present specification, the term "process" as used herein includes not only an independent process but also a process that is not clearly distinguishable from one another, so long as it can attain its object. The numerical value range expressed as "A to B" indicates a range that includes A as a maximum value and B as a minimum value, respectively. Furthermore, unless otherwise indicated, when there are plural kinds of substances that correspond to a component, the content of the component refers to the total contents of the substances. The term "layer" includes a construction having a shape formed on a part of a region, in addition to a construction having a shape formed on an entire region.

### (First embodiment)

The passivation film of the present embodiment is a passivation film used for a silicon photovoltaic cell element, and includes aluminum oxide and niobium oxide.

By including aluminum oxide and niobium oxide in the passivation film, the carrier lifetime of a silicon substrate can be prolonged and a silicon substrate can have a negative fixed charge. Therefore, the passivation film of the present invention can improve the photoelectric conversion efficiency of a silicon photovoltaic cell. Further, since the passivation film of the present invention can be formed using a coating method or a printing method, the film formation process is simple and the throughput rate of forming the film is high. As a result, pattern formation is simple and enables cost reduction.

In the present embodiment, the amount of the fixed charge of the passivation film can be controlled by changing the composition of the passivation film.

General functions of a passivation film include [1] termination of a dangling bond, and [2] band bending by fixed charge in the film. Among these, a passivation film utilizing a function of band bending is referred to as a passivation film having an electrical field effect, and recombination is suppressed by driving back either holes or electrons using the charge. Therefore, in order to drive electrons back toward the light receiving surface, a passivation film having an electrical field effect has to be used on a back surface of a p-type silicon substrate (see, for example, Japanese Patent Application Laid-Open No. 2012-33759).

In contrast, in the present embodiment, by using both of niobium oxide and aluminum oxide, a passivation film can have a negative fixed charge. Moreover, when a mass ratio of niobium oxide and aluminum oxide [niobium oxide / aluminum oxide] is from 30/70 to 90/10, a large stable negative fixed charge tends to be obtained. As described above, a passivation film of the present invention can be formed by using a coating method or printing method and, therefore, the film formation process is simple and the throughput rate of forming a film is high. As a result, pattern formation is simple and enables cost reduction.

From the viewpoint of stabilizing a negative fixed charge, the mass ratio of niobium oxide and aluminum oxide is preferably from 30/70 to 80/20. From the viewpoint of further stabilizing a negative fixed charge, the mass ratio of niobium oxide and aluminum oxide is more preferably from 35/65 to 70/30. From the viewpoint of achieving both an improvement in carrier lifetime and a negative fixed charge, the mass ratio of niobium oxide and aluminum oxide is preferably from 50/50 to 90/10.

The mass ratio of niobium oxide and aluminum oxide in the passivation film can be measured by energy dispersive X-ray spectrometry (EDX), secondary ion mass spectrometry (SIMS) and induced coupled plasma-mass spectrometry (ICP-MS). Specific conditions for the measurement are as follows. A passivation film is dissolved in an acid or an alkaline aqueous solution, and the resulting solution is atomized and introduced in an Ar plasma. Then, a light that is released when an excited element returns to the ground state is dispersed, and its wavelength and intensity are measured. Then, qualitative analysis of the element is performed from the resulting wavelength, and quantitative analysis is performed from the resulting intensity.

The total content of niobium oxide and aluminum oxide in the passivation film is preferably 80% by mass or more, and more preferably 90% by mass or more, from the viewpoint of maintaining favorable properties. The more the content of niobium oxide and aluminum oxide in the passivation film is, the greater the effect of the negative fixed charge is.

The total content of niobium oxide and aluminum oxide in the passivation film can be measured by thermogravimetric analysis, fluorescent X-ray analysis, ICP-MS, and X-ray absorption spectroscopy in combination. Specific conditions for the measurement are as follows. The proportion of an inorganic component is calculated by thermogravimetric analysis, the proportion of niobium and aluminum is calculated by fluorescent X-ray or ICP-MS analysis, and the proportion of an oxide is determined by X-ray absorption spectroscopy.

From the viewpoint of improving the film quality and adjusting the elasticity, the passivation film may include a component other than niobium oxide and aluminum oxide as an organic component. The existence of an organic component in the passivation film can be confirmed by elemental analysis and FT-IR measurement of the film.

The content of an organic component in the passivation film is preferably less than 10% by mass, more preferably less than 5% by mass or less, and still more preferably 1% by mass or less, in the passivation film.

The passivation film may be obtained as a thermally-treated product of a coating material that includes an aluminum oxide precursor and a niobium oxide precursor. The details of the coating material are described below.

### (Second Embodiment)

The coating material of the present embodiment includes an aluminum oxide precursor and a niobium oxide precursor, and is used for the formation of a passivation film for a photovoltaic cell element having a silicon substrate.

The aluminum oxide precursor is not particularly limited so long as it can produce an aluminum oxide. As an aluminum oxide precursor, an organic aluminum oxide precursor is preferably used in view of dispersing aluminum oxide onto a silicon substrate in a uniform manner, and chemical stability. Examples of the organic aluminum oxide precursor include an aluminum triisopropoxide (structural formula: Al(OCH(CH₃)₂)₃, Kojundo Chemical Lab. Co., Ltd., SYM-AL04.

The niobium oxide precursor is not particularly limited so long as it produces niobium oxide. As a niobium oxide precursor, an organic niobium oxide precursor is preferably used from the viewpoint of dispersing the niobium oxide precursor onto a silicon substrate in a uniform manner and chemical stability. Examples of the organic niobium oxide precursor include niobium (V) ethoxide (structural formula: Nb(OC₂H₅)₅, molecular weight: 318.21), Kojundo Chemical Lab. Co., Ltd., Nb-05.

The coating material including an organic-based niobium oxide precursor and an organic-based aluminum oxide precursor may be used to obtain a passivation film by forming a film by coating or printing, and removing an organic component by the subsequent thermal treatment (sintering). Therefore, as a result, the passivation film may include an organic component.

### (Third Embodiment)

The photovoltaic cell element (photoelectric conversion element) of the present embodiment has passivation film explained in the first embodiment (insulation film, protecting insulation film) that includes aluminum oxide and niobium oxide adjacent to a photoelectric conversion surface of a silicon substrate. By including aluminum oxide and niobium oxide, a carrier lifetime of a silicon substrate is prolonged and a silicon substrate has a negative fixed charge, thereby enabling to improve a property (efficiency of photoelectric conversion).

### <Description of Structure >

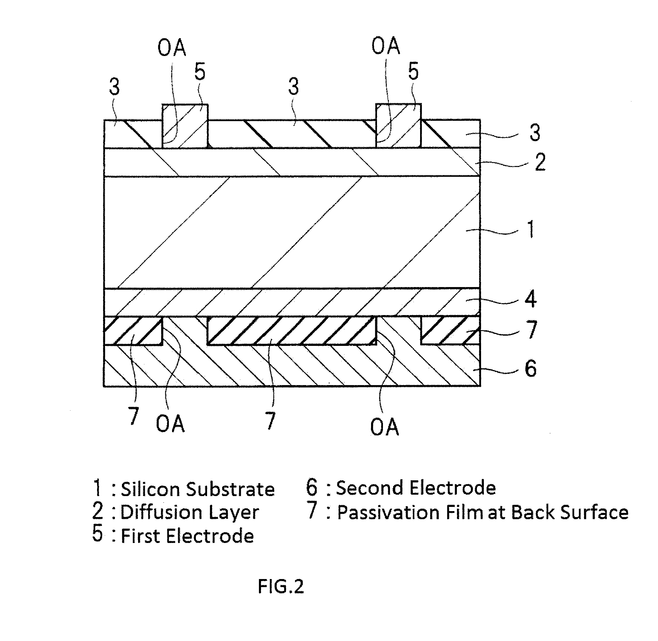

The structure of a photovoltaic cell element of the embodiment will be illustrated by referring to Figures 2 to 5. Figures 2 to 5 are cross sectional views of first to fourth structural examples in which a passivation film is provided at a back surface of the embodiment.

Silicon substrate 1 (a crystalline silicon substrate, a semiconductor substrate) used in the present invention may be either monocrystalline silicon or polycrystalline silicon. Further, silicon substrate 1 may be either crystalline silicon having a p-type conductivity or crystalline silicon having an n-type conductivity. From the viewpoint of exhibiting an effect of the embodiment, a crystalline silicon having a p-type conductivity is more suitable.

In Figures 2 to 5, an example in which a p-type monocrystalline silicon as silicon substrate 1 is used is illustrated. The type of the monocrystalline silicon or polycrystalline silicon used for silicon substrate 1 is not particularly limited, but a monocrystalline silicon or a polycrystalline silicon having a resistivity of from 0.5 Ω·cm to 10 Ω·cm is preferred.

As shown in Figure 2 (first structural example), n-type diffusion layer 2 doped with a V-group element such as phosphorus is formed at a light receiving surface (upper side in the drawing, a first surface) of p-type silicon substrate 1. Then, a pn conjunction is formed between silicon substrate 1 and diffusion layer 2. On a surface of diffusion layer 2, light receiving surface anti-reflection film 3 such as a silicon nitride (SiN) film, and first electrode 5 (an electrode formed at the light receiving surface, a first electrode, a top electrode or a light receiving surface electrode) of silver (Ag) or the like are formed. Light receiving surface anti-reflection film 3 may function as a passivation film of a light receiving surface. By using a SiN film, the film can function as an anti-reflection film of a light receiving surface and function as a passivation film of a light receiving surface, respectively.

The photovoltaic cell element of the embodiment may have light receiving surface anti-reflection film 3, or may not. At the light receiving surface of a photovoltaic cell element, it is preferred to form a concave-convex structure (textured structure) in order to reduce the reflectivity at the surface. However, a photovoltaic cell element of the embodiment may not have a textured structure.

At the back surface (lower side in the drawing, second surface or a back surface) of silicon substrate 1, BSF (Back Surface Field) layer 4, which is a layer doped with a III-group element such as aluminum or boron, is formed. However, the photovoltaic cell element of the embodiment may include BSF layer 4, or may not.

At the back surface of silicon substrate 1, second electrode 6 (a back surface electrode, a second electrode or a back surface electrode) formed of aluminum or the like is formed in order to achieve a contact (electrical contact) with BSF layer 4 (or the back surface of silicon substrate 1 when BSF layer 4 is not formed).

In addition, in Figure 2 (first constitutional example), passivation film (a passivation layer) 7 that includes aluminum oxide and niobium oxide is formed at an area excluding a contact region (opening OA) at which BSF layer 4 (or back surface of the silicon substrate 1 when BSF layer 4 is not formed) and second electrode 6 are electrically connected. Passivation film 7 of the present embodiment may have a negative fixed charge as explained in first embodiment in detail. By this fixed charge, electrons that correspond to minority carriers among those generated in silicon substrate 1 by light are reflected toward the surface side. Therefore, it is expected that a short-circuit current is increased and an incident photoelectric conversion efficiency is improved.

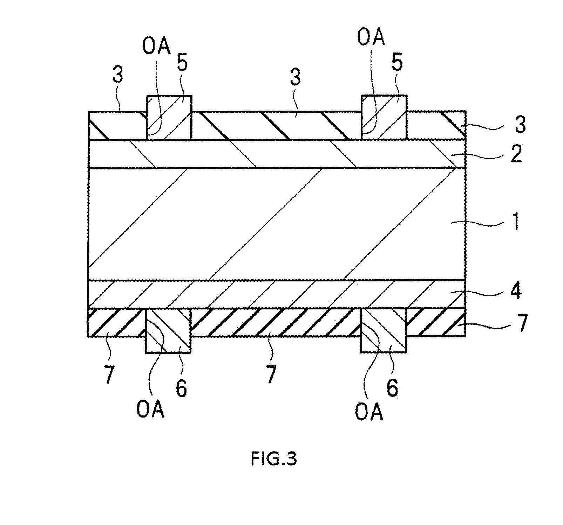

Next, a second constitutional example shown in Figure 3 will be explained. In Figure 2 (first constitutional example), second electrode 6 is formed at a contact region (an opening OA) and at an entire surface of passivation film 7. In Figure 3 (second constitutional example), second electrode 6 is formed only at a contact region (opening OA). It is also possible that second electrode 6 is formed at a contact region (opening OA) and at a portion of passivation film 7. With the photovoltaic cell element having a constitution shown in Figure 3, a similar effect to the photovoltaic cell element shown in Figure 2 (first constitutional example) can be obtained.

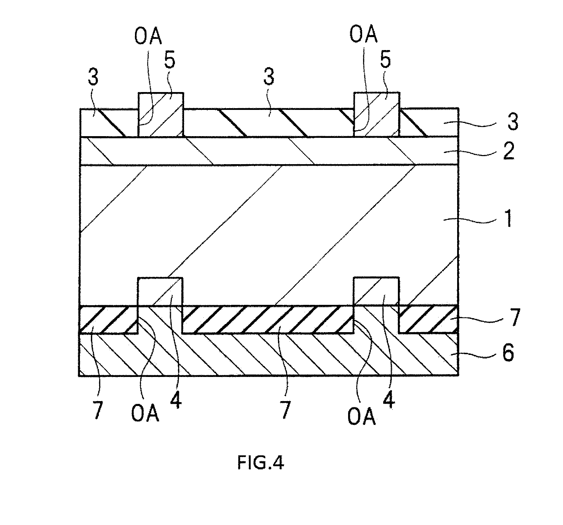

Subsequently, a third constitutional example shown in Figure 4 will be explained. In the third constitutional example shown in Figure 4, BSF layer 4 is formed only at a portion of a back surface including a contact region (opening OA) with second electrode 6, rather than at an entire area of the back surface as shown in Figure 2 (first constitutional example). A photovoltaic cell element having a constitution as described above (Figure 4) can exhibit a similar effect to the photovoltaic cell element shown in Figure 2 (first constitutional example). Further, in the photovoltaic cell element of the third constitutional example as shown in Figure 4, since the area of BSF layer 4, i.e., the region that is doped with an impurity such as a III-group element such as aluminum or boron at a higher concentration than that of silicon substrate 1 is small. Therefore, it is possible to obtain a higher incident photoelectric conversion efficiency than the photovoltaic cell element shown in Figure 2 (first constitutional example).

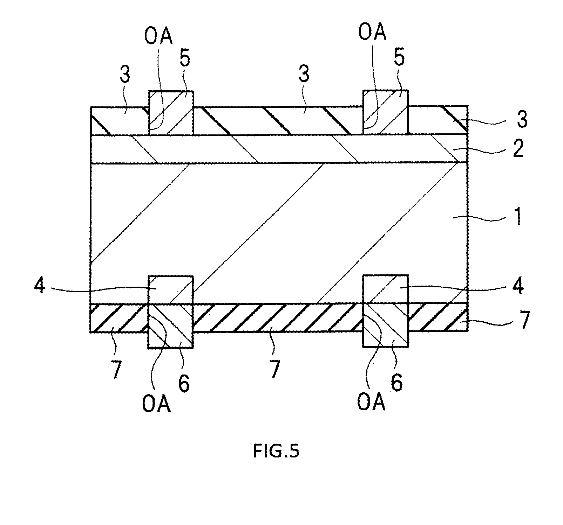

Subsequently, a fourth constitutional example shown in Figure 5 will be explained. In Figure 4 (third constitutional example), second electrode 6 is formed at a contact region (opening OA) and at an entire surface of passivation film 7. In Figure 5 (fourth constitutional example), second electrode 6 is formed only at a contact region (opening OA). Second electrode 6 may be formed at the contact region (opening OA) and at a portion of passivation film 7. With a photovoltaic cell element shown in Figure 5, a similar effect to the photovoltaic cell element shown in Figure 4 (third constitutional example) can be obtained.

In the case in which second electrode 6 is formed at an entire back surface by printing and sintering at high temperature, a convex warpage tends to occur as the temperature decreases. Such a warpage may cause a damage to a photovoltaic cell element and affect the production yield. Further, as the thickness of a silicon substrate becomes smaller, the problem associated with a warpage becomes greater. The warpage is caused by a stress generated by contraction of second electrode 6 including a metal (such as aluminum) that is greater than that of a silicon substrate, which occurs during the temperature decrease because of its greater thermal expansion coefficient than that of the silicon substrate.

As described above, it is preferred not to form second electrode 6 on an entire area of the back surface, as is shown in Figure 3 (second constitutional example) and Figure 5 (fourth constitutional example), because the electrode structures at the upper and lower sides tend to be symmetry and a stress caused by a difference in the thermal expansion coefficient is less likely to occur. In that case, however, it is preferred to provide an anti-reflection layer.

### <Description of producing method >

Subsequently, an example of a method for producing a photovoltaic cell element of the present invention having a constitution as described above (Figures 2 to 5) will be explained. However, the present invention is not limited to a photovoltaic cell element that is prepared by the method described below.

First, a textured structure is formed at a surface of silicon substrate 1, as shown in Figure 2 and the like. The textured structure may be formed at both sides of silicon substrate 1, or only at one side (a light receiving surface side) of silicon substrate 1. In order to form a textured structure, silicon substrate 1 is immersed in a heated solution of potassium hydroxide or sodium hydroxide to remove a damaged layer of silicon substrate 1. Subsequently, by immersing silicon substrate 1 in a solution including potassium hydroxide and isopropyl alcohol as major components, a textured structure is formed at both sides or at one side (a light receiving surface side) of silicon substrate 1. As described above, this process may be omitted because the photovoltaic cell element of the present invention may have a textured structure or may not.

Subsequently, after washing silicon substrate 1 with a solution of hydrochloric acid, hydrofluoric acid or the like, a phosphorus diffusion layer (n⁺ layer) is formed as diffusion layer 2 on silicon substrate 1 by performing thermal diffusion of phosphorus oxychloride (POCl₃) or the like. The phosphorus diffusion layer may be formed by, for example, coating an coating-type doping material solution containing phosphorus to silicon substrate 1 and performing thermal treatment. After the thermal treatment, by removing the phosphorus glass layer formed at a surface with an acid such as hydrofluoric acid, a phosphorus diffusion layer (n⁺ layer) is formed as diffusion layer 2. The method of forming a phosphorus diffusion layer is not particularly limited. It is preferred to form a phosphorus diffusion layer such that the depth is in the range of from 0.2 µm to 0.5 µm from the surface of silicon substrate 1, and the sheet resistance is in the range of from 40 Ω/square to 100 Ω/square (ohm/square).

Subsequently, BSF layer 4 is formed at a back surface by coating an coating doping material solution including boron, aluminum or the like on a back surface of silicon substrate 1 and performing thermal treatment. For the coating, a method such as screen printing, ink-jetting, dispensing and spin coating may be used. After the thermal treatment, BSF layer 4 is formed by removing a layer of boron glass, aluminum or the like that is formed at the back surface with hydrofluoric acid, hydrochloric acid or the like. The method of forming BSF layer 4 is not particularly limited. Preferably, BSF layer 4 is formed such that the concentration of boron, aluminum or the like is in the range of from 10¹⁸ cm⁻³ to 10²² cm⁻³, and BSF layer 4 is formed in the form of a dot or a line. Since the photovoltaic cell element of the present invention may include BSF layer 4 or may not, this process may be omitted.

Further, when both diffusion layer 2 at the light receiving surface, and BSF layer 4 at the back surface are formed with an coating solution of a doping material, it is possible to coat the doping material solution onto both sides of silicon substrate 1, form a phosphorus diffusion layer (n⁺ layer) as diffusion layer 2 and BSF layer 4 at one process, and then remove phosphorus glass, boron glass, or the like formed on the surface at one process.

Subsequently, a silicon nitride film, which is light receiving surface anti-reflection film 3, is formed on diffusion layer 2. The method of forming light receiving surface anti-reflection film 3 is not particularly limited. It is preferred to form light receiving surface anti-reflection film 3 such that the thickness is in the range of from 50 to 100 nm, and the refractive index is in the range of from 1.9 to 2.2. Light receiving surface anti-reflection film 3 is not limited to a silicon nitride film, and may be a silicon oxide film, an aluminum oxide film, a titanium oxide film or the like. Light receiving surface anti-reflection film 3 such as a silicon nitride film may be formed by plasma CVD, thermal CVD or the like, and is preferably formed by plasma CVD that can be performed at a temperature range of from 350°C to 500°C.

Subsequently, passivation film 7 is formed at the back surface of silicon substrate 1. Passivation film 7 includes aluminum oxide and niobium oxide, and is formed by, for example, coating a material (a passivation material) including: an aluminum oxide precursor represented by a metal-organic-decomposition coating material that produces aluminum oxide upon thermal treatment (sintering); and a niobium oxide precursor represented by a commercially available metal-organic-decomposition coating material that produces niobium oxide upon thermal treatment (sintering), and performing thermal treatment (sintering) (See the first embodiment).

Passivation film 7 may be formed by a process as described below, for example. The coating material is coated by spin coating onto one side of a p-type silicon substrate (from 8 Ωcm to 12 Ωcm) of 8 inches (20.32 cm) with a thickness of 725 µm, from which a spontaneously oxidized film had been removed in advance with hydrofluoric acid at a concentration of 0.049% by mass. Then, the silicon substrate is placed on a hot plate and pre-baked at 120°C for 3 minutes. Subsequently, thermal treatment (sintering) is performed at 650°C for an hour in a nitrogen atmosphere. In that case, a passivation film including aluminum oxide and niobium oxide is obtained. The film thickness of passivation film 7 formed by the above method as measured with an ellipsometer is generally approximately several ten nm.

The above coating material is coated by printing such as screen printing, offset printing, ink-jet printing, or with a dispenser, in the form of a predetermined pattern including a contact region (opening OA). Passivation film 7 (oxide film) is preferably formed by evaporating a solvent by performing pre-baking to the coating material in a temperature range of 80°C to 180°C after coating thereof, and performing thermal treatment (annealing) in a nitrogen atmosphere or an air atmosphere at a temperature of from 600°C to 1000°C for approximately 30 minutes to approximately 3 hours.

Opening (opening for contact) OA is preferably formed on BSF layer 4 in the form of a dot or a line.

Passivation film 7 used for the photovoltaic cell element as described in the first embodiment preferably has a mass ratio of niobium oxide and aluminum oxide (niobium oxide /aluminum oxide) of from 30/70 to 90/10, more preferably from 30/70 to 80/20, and still more preferably from 35/65 to 70/30. By satisfying this range, a negative fixed charge can be stabilized. From the viewpoint of attaining both improvement in carrier lifetime and a negative fixed charge, the mass ratio of niobium oxide and aluminum oxide is preferably from 50/50 to 90/10.

Further, passivation film 7 preferably has a total content of niobium oxide and aluminum oxide of 80% by mass or more, and more preferably 90% by mass or more.

Subsequently, first electrode 5, which is formed at the light receiving surface side, is formed. First electrode 5 is formed by coating a paste mainly composed of silver (Ag) onto light receiving surface anti-reflection film 3 by screen printing, and performing thermal treatment (i.e. fire through). The shape of first electrode 5 may be any form, such as a known shape formed of a finger electrode and a bus bar electrode.

Then, second electrode 6, which is a back surface electrode, is formed. Second electrode 6 may be formed by coating a paste mainly composed of aluminum by screen printing or with a dispenser, and subjecting the paste to thermal treatment. The shape of second electrode 6 is preferably the same shape as that of BSF layer 4, a shape covering the entire back surface, a comb-shape, a lattice-shape, or the like. It is also possible to perform printing of the paste for forming first electrode 5, which is an electrode formed at the light receiving surface side, and perform printing of the paste for forming second electrode 6, and subsequently performing thermal treatment (sintering) to form first electrode 5 and second electrode 6 at one process.

By using a paste mainly composed of aluminum (Al) for the formation of second electrode 6, aluminum diffuses as a dopant and BSF layer 4 is formed at a contact portion of second electrode 6 and silicon substrate 1 by self-aligning. As mentioned previously, BSF layer 4 may be formed separately by coating an coating solution of a doping material containing boron, aluminum or the like, and subjecting the same to thermal treatment.

In the above description, although a p-type silicon is used as silicon substrate 1 in the structural and production examples, an n-type silicon may be used as silicon substrate 1. In that case, diffusion layer 2 is formed as a layer doped with a III-group element such as boron, and BSF layer 4 is formed by doping a V-group element such as phosphorus. However, it should be noted that there are cases in which a leakage current flows through a portion at which an inversion layer formed at an interface by a negative fixed charge contacts a metal at the back surface side, and it is difficult to increase conversion efficiency.

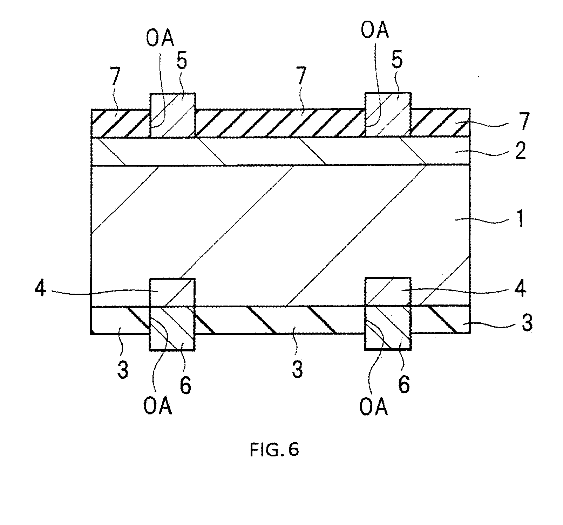

In a case in which an n-type silicon substrate is used, passivation film 7 that includes niobium oxide and aluminum oxide can be used at the light receiving surface, as shown in Figure 6.

Figure 6 shows a constitutional example of a photovoltaic cell element in which a light receiving surface passivation film of the present embodiment is used.

In that case, diffusion layer 2 formed at the light receiving surface is converted to p-type by doping with boron, and among the generated carriers, holes are collected at the light receiving surface side and electrons are collected at the back surface side. Therefore, passivation film 7, which has a negative fixed charge, is preferably formed at the light receiving surface side.

On the passivation film that includes niobium oxide and aluminum oxide, an anti -reflection film composed of SiN or the like may be further formed by CVD or the like.

### (Fourth embodiment)

The a semiconductor substrate having a passivation film of the present embodiment includes a silicon substrate and a passivation film explained in the first embodiment, which includes aluminum oxide and niobium oxide, which is provided on an entire or partial surface of the silicon substrate. By including aluminum oxide and niobium oxide, a carrier lifetime of a silicon substrate is prolonged and a silicon substrate has a negative fixed charge, thereby enabling to improve a property (efficiency of photoelectric conversion).

### EXAMPLES

In the following, details of the present embodiment will be explained by referring to the Reference Examples and the Comparative Examples.

### [Example 1]

Passivation material (a-1) as a coating material was prepared by mixing 3.0 g of a commercially available metal-organic-decomposition coating material [Kojundo Chemical Lab. Co., Ltd., SYM-AL04, concentration: 2.3% by mass], from which aluminum oxide (Al₂O₃) is obtained upon thermal treatment (sintering), and 3.0 g of a commercially available metal-organic-decomposition coating material [Kojundo Chemical Lab. Co., Ltd., Nb-05, concentration: 5% by mass], from which niobium oxide (Nb₂O₅) is produced upon thermal treatment (sintering).

Passivation material (a-1) was coated by spin-coating on one side silicon substrate (from 8 Ω·cm to 12 Ω·cm) having a size of 8 inches and 725 µm in thickness, from which a spontaneously oxidized film had been previously removed with hydrofluoric acid at 0.049% by mass concentration, and the silicon substrate was pre-baked on a hot plate at 120°C for 3 minutes. Subsequently, thermal treatment (sintering) was performed under a nitrogen atmosphere at 650°C for an hour, thereby obtaining a passivation film including aluminum oxide and niobium oxide [niobium oxide /aluminum oxide = 68/32]. The film thickness as measured with an ellipsometer was 43 nm. As a result of FT-IR measurement of the passivation film, a slight peak derived from an alkyl group was observed at approximately 1,200 cm⁻¹.

Subsequently, a capacitor having a MIS (metal-insulator-semiconductor) structure was prepared by forming plural aluminum electrodes having a diameter of 1 mm on the passivation film by vapor deposition though a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.32 V. From this amount of shift, it was found that the passivation film obtained from passivation material (a-1) exhibited a negative fixed charge at a fixed charge density (Nf) of -7.4 × 10¹¹ cm⁻².

In the same manner as the above, passivation material (a-1) was coated onto both sides of an 8-inch p-type silicon substrate. Then, the silicon substrate was pre-baked and subjected to thermal treatment (sintering) under a nitrogen atmosphere at 650°C for an hour, thereby preparing a sample of a silicon substrate having both sides covered with a passivation film. The carrier lifetime of this sample was measured with a lifetime measurement device (Kobelco Research Institute Inc., RTA-540). As a result, the carrier lifetime was 530 µs. For comparison, the carrier lifetime of the same 8-inch p-type silicon substrate, which was passivated by an iodine passivation method, was measured. The result was 1,100 µs.

From the above description, it was found that a passivation film obtained by thermal treatment (sintering) of the passivation material (a-1) exhibited a certain degree of passivation performance, and had a negative fixed charge.

### [Example 2]

In the same manner as Example 1, a commercially available metal-organic decomposition coating material [Kojundo Chemical Lab. Co., Ltd., SYM-AL04, concentration: 2.3% by mass] from which aluminum oxide (Al₂O₃) is obtained upon thermal treatment (sintering) and a commercially available metal-organic decomposition coating material [Kojundo Chemical Lab. Co., Ltd., Nb-05, concentration: 5% by mass] from which niobium oxide (Nb₂O₅) is obtained upon thermal treatment (sintering) were mixed at different ratios, and passivation materials (a-2) to (a-7) shown in Table 1 were prepared.

In the same manner as Example 1, a passivation film was prepared by coating each of passivation materials (a-2) to (a-7) onto one side silicon substrate, and performing thermal treatment (sintering). The voltage dependency of the electrostatic capacitance of the resulting passivation film was measured, and the fixed charge density was calculated therefrom.

Further, in the same manner as Example 1, a sample was prepared by coating a passivation material onto both sides silicon substrate, and performing thermal treatment (sintering). The sample was used for the measurement of carrier lifetime. The results are summarized in Table 1.

Since passivation materials (a-2) to (a-7) exhibited a certain degree of carrier lifetime after thermal treatment (sintering), although the results were different depending on the ratios of niobium oxide/aluminum oxide (mass ratio) after thermal treatment (sintering), it was suggested that these passivation materials were capable of functioning as passivation films. It was found that all of the passivation films obtained from passivation materials (a-2) to (a-7) exhibited a negative fixed charge in a stable manner, and that the passivation films were suitable for the purpose of passivating a p-type silicon substrate.

**Table 1**

| Material | Niobium Oxide/Aluminum Oxide After Thermal treatment (Mass Ratio) | Film Thickness After Thermal treatment (nm) | Fixed Charge Density (cm⁻²) | Carrier Lifetime (µs) |
|---|---|---|---|---|
| a-2 | 30/70 | 35 | -1.1×10¹⁰ | 610 |
| a-3 | 40/60 | 42 | -2.1×10¹⁰ | 540 |
| a-4 | 50/50 | 41 | -7.1×10¹⁰ | 530 |
| a-5 | 60/40 | 42 | -4.1×10¹¹ | 400 |
| a-6 | 80/20 | 53 | -8.3×10¹¹ | 280 |
| a-7 | 90/10 | 55 | -9.5×10¹¹ | 100 |

### [Example 3]

3.18 g (0.010 mol) of a commercially available niobium (V) ethoxide (structural formula: Nb(OC₂H₅)₅, molecular weight: 318.21) and 1.02 g (0.005 mol) of a commercially available aluminum triisopropoxide (structural formula: Al(OCH(CH₃)₂)₃, molecular weight: 204.25) were dissolved in 80 g of cyclohexane, and passivation material (c-1) at a concentration of 5% by mass was prepared.

Passivation material (c-1) was coated by spin coating on one side silicon substrate (from 8 Ω·cm to 12 Ω·cm) having a size of 8 inches and 725 µm in thickness, from which a spontaneously oxidized film had been previously removed with hydrofluoric acid at 0.049% by mass concentration, and the silicon substrate was pre-baked on a hot plate at 120°C for 3 minutes. Subsequently, thermal treatment (sintering) was performed under a nitrogen atmosphere at 600°C for an hour, thereby obtaining a passivation film including aluminum oxide and niobium oxide. The film thickness as measured with an ellipsometer was 50 nm. As a result of elemental analysis, the ratio Nb/Al/C was 81/14/5 (% by mass). As a result of FT-IR measurement of the passivation film, a slight peak derived from an alkyl group was observed at approximately 1,200 cm⁻¹.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +4.7 V. From this amount of shift, it was found that the passivation film obtained from passivation material (c-1) exhibited a negative fixed charge at a fixed charge density (Nf) of -3.2 × 10¹² cm⁻².

In the same manner as the above, passivation material (c-1) was coated onto both sides of an 8-inch p-type silicon substrate, and the silicon substrate was pre-baked and subjected to thermal treatment (sintering) under a nitrogen atmosphere at 600°C for an hour, and a sample of a silicon substrate having both sides covered with a passivation film was prepared. The carrier lifetime of the sample was measured with a lifetime measurement device (Kobelco Research Institute Inc., RTA-540). As a result, the carrier lifetime was 330 µs. For comparison, the carrier lifetime of the same 8-inch p-type silicon substrate that had been passivated by an iodine passivation method was measured. The result was 1,100 µs.

In view of the above, it was found that a passivation film obtained by performing thermal treatment (sintering) to the passivation material (c-1) exhibited a certain degree of passivation performance and a negative fixed charge.

### [Example 4]

Passivation material (c-2) was prepared by dissolving 2.35 g (0.0075 mol) of a commercially available niobium (V) ethoxide (structural formula: Nb(OC₂H₅)₅, molecular weight: 318.21), 1.02 g (0.005 mol) of a commercially available aluminum triisopropoxide (structural formula: Al(OCH(CH₃)₂)₃, molecular weight: 204.25) and 10 g of a novolac resin in 10 g of diethyleneglycol monobutyl ether acetate and 10 g of cyclohexane.

Passivation material (c-2) was coated by spin coating onto one side of a p-type silicon substrate (from 8 Ω·cm to 12 Ω·cm) having a size of 8 inches and 725 µm in thickness, from which a spontaneously oxidized film had been previously removed with hydrofluoric acid at 0.049% by mass concentration. The silicon substrate was pre-baked on a hot plate at 120°C for 3 minutes. Subsequently, thermal treatment (sintering) was performed under a nitrogen atmosphere at 600°C for an hour, and a passivation film including aluminum oxide and niobium oxide was prepared. The film thickness as measured with an ellipsometer was 14 nm. As a result of elemental analysis, the ratio Nb/Al/C was 75/17/8 (% by mass). As a result of FT-IR measurement of a passivation film, a slight peak derived from an alkyl group was observed at approximately 1,200 cm⁻¹.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.10V. From this amount of shift, it was found that the passivation film obtained from passivation material (c-2) exhibited a negative fixed charge at a fixed charge density (Nf) of -0.8 × 10¹¹ cm⁻².

In view of the above, passivation material (c-2) was coated on both sides of an 8-inch p-type silicon substrate. The silicon substrate was pre-baked and subjected to thermal treatment (sintering) under a nitrogen atmosphere at 600°C for an hour, and a sample of a silicon substrate having both sides covered with a passivation film was prepared. The carrier lifetime of the sample was measured with a lifetime measuring assembly (Kobelco Research Institute Inc., RTA-540). As a result, the carrier lifetime was 200 µs. For comparison, the carrier lifetime of the same 8-inch p-type silicon substrate, which was passivated by an iodine passivation method, was measured. The result was 1,100 µs.

In view of the above, it was found that a passivation film obtained by performing thermal treatment (sintering) of passivation material (c-2) exhibited a certain degree of passivation performance and a negative fixed charge.

### [Example 5 and Comparative Example 1]

In the same manner as Example 1, a commercially available metal-organic decomposition coating material [Kojundo Chemical Lab. Co., Ltd., SYM-AL04, concentration: 2.3% by mass] from which aluminum oxide (Al₂O₃) is obtained upon thermal treatment (sintering), a commercially available metal-organic decomposition coating material [Kojundo Chemical Lab. Co., Ltd., Nb-05, concentration: 5% by mass] from which niobium oxide (Nb₂O₅) is obtained upon thermal treatment (sintering) were mixed at different ratios, and passivation materials (b-1) to (b-7) shown in Table 2 were prepared.

In the same manner as Example 1, a passivation film was prepared by coating each of passivation materials (b-1) to (b-7) on one side of a p-type silicon substrate and performing thermal treatment (sintering). By using the passivation film, voltage dependency of the electrostatic capacitance was measured and a fixed charge density was calculated therefrom.

In the same manner as Example 1, a sample obtained by coating a passivation material (an coating material) on both sides of a p-type silicon substrate and curing the same was used for the measurement of a carrier lifetime. The results are shown in Table 2.

**Table 2**

| Material | Niobium Oxide/Aluminum Oxide after Thermal treatment (Mass Ratio) | Film Thickness after Thermal treatment (nm) | Fixed Charge Density (cm⁻²) | Carrier Lifetime (µs) |
|---|---|---|---|---|
| b-1 | 10/90 | 35 | 2.3×10¹¹ | 600 |
| b-2 | 20/80 | 36 | 2.2×10¹¹ | 540 |
| b-3 | 10/90 | 40 | 1.1×10¹⁰ | 480 |
| b-4 | 10/90 | 42 | -1.2×10¹⁰ | 520 |
| b-5 | 20/80 | 45 | -1.0×10¹⁰ | 440 |
| b-6 | 20/80 | 38 | 1.3×10¹⁰ | 470 |
| b-7 | 0/100 | 34 | 2.2×10¹¹ | 600 |

It was found that all of the passivation films obtained from passivation materials (b-1) to (b-6) had a long carrier lifetime and were capable of functioning as a passivation film. In the cases in which niobium oxide / aluminum oxide was 10/90 and 20/80, there was a significant variability among the values of the fixed charge density and a negative fixed charge density was not obtained in a stable manner. However, it was confirmed that a negative fixed charge density could be achieved by using aluminum oxide and niobium oxide. When the measurement was performed by a CV method using a passivation material in which niobium oxide /aluminum oxide was 10/90 and 20/80, the resulting passivation film exhibited a positive fixed charge in some cases, and did not exhibit a negative fixed charge in a stable manner. A passivation film that exhibits a positive fixed charge can be used for passivation of an n-type silicon substrate.

On the other hand, a negative fixed charge density could not be obtained from passivation material (b-7) composed of 100% by mass of aluminum oxide.

### [Comparative Example 2]

As passivation material (d-1), a commercially available metal-organic decomposition coating material [Kojundo Chemical Lab. Co., Ltd., Ti-03-P, concentration: 3% by mass] from which titanium oxide (TiO₂) is obtained upon thermal treatment (sintering); as a passivation material (d-2), a commercially available metal-organic decomposition coating material [Kojundo Chemical Lab. Co., Ltd., BT-06, concentration: 6% by mass] from which barium titanate (BaTiO₃) is obtained upon thermal treatment (sintering); and as passivation material (d-3), a commercially available metal-organic decomposition coating material [Kojundo Chemical Lab. Co., Ltd., Hf-05, concentration: 5% by mass] from which hafnium oxide (HfO₂) is obtained upon thermal treatment (sintering), were prepared.

In the same manner as Example 1, each of passivation materials (d-1) to (d-3) was coated on one side silicon substrate, and the silicon substrate was subjected to thermal treatment (sintering) to prepare a passivation film. The passivation film was used for the measurement of voltage dependency of electrostatic capacitance, and a fixed charge density was calculated therefrom.

Moreover, in the same manner as Example 1, a passivation material was coated on both sides of a p-type silicon substrate, and the carrier lifetime was measured using a sample obtained by performing thermal treatment (sintering). The results are shown in Table 3.

**Table 3**

| Material | Metal Oxide | Film Thickness after Thermal treatment (nm) | Fixed Charge Density (cm⁻²) | Carrier Lifetime (µs) |
|---|---|---|---|---|
| d-1 | TiO₂ | 53 | 5.0×10⁹ | 4 |
| d-2 | BaTiO₃ | 51 | 4.2×10⁹ | 5 |
| d-3 | HfO₂ | 60 | -4.0×10⁸ | 54 |

All of the passivation film obtained from passivation materials (d-1) to (d-3) exhibited a small carrier lifetime, and exhibited an insufficient passivation performance. In addition, these passivation films exhibited a positive fixed charge. A passivation film obtained from passivation material (d-3) exhibited a negative fixed charge, but the value was small. In addition, the carrier lifetime was relatively small, which proved an insufficient function as a passivation film.

From the results of the Examples and Comparative Examples, the following points are considered.

From the viewpoint of obtaining a passivation film having negative fixed charge and stabilizing a negative fixed charge by using both of niobium oxide and aluminum oxide, the mass ratio of niobium oxide and aluminum oxide [niobium oxide / aluminum oxide (% by mass)] is preferably from 30/70 to 90/10 (i.e. 30/70 or more but 90/10 or less), and more preferably from 30/70 to 80/20. From the viewpoint of the compatibility of improving carrier lifetime and negative fixed charge, the mass ratio of niobium oxide and aluminum oxide is preferably from 50/50 to 90/10.

From the results of measurement of elemental analysis and FT-IR measurement of the film, the existence of an organic component other than niobium oxide and aluminum oxide in the passivation film is confirmed. The content of niobium oxide and aluminum oxide, i.e., the content by mass of niobium oxide and aluminum oxide in a passivation film, is preferably 80% or more, and more preferably 90% or more, whereby excellent properties can be maintained.

### [Example 6]

A photovoltaic cell element of a structure shown in Figure 4 was prepared using a monocrystalline silicon substrate doped with boron as silicon substrate 1. After performing texture processing to a surface of silicon substrate 1, the coating-type phosphorus diffusion material was coated onto a light receiving surface, and diffusion layer 2 (a phosphorus diffusion layer) was formed by performing thermal treatment. Subsequently, the coating-type phosphorus diffusion material was removed with dilute hydrofluoric acid.

Subsequently, a SiN film was formed by plasma CVD as light receiving surface anti-reflection film 3 on a light receiving surface. Then, passivation material (a-1) as prepared in Example 1 was coated onto a region excluding a contact region (opening OA) at a back surface of silicon substrate 1 by an ink-jet method. Subsequently, passivation film 7 having opening OA was formed by performing thermal treatment.

As a sample, passivation film 7 was prepared, by using passivation material (c-1) prepared in Example 3.

Subsequently, on light receiving surface anti-reflection film 3 (SiN film) formed on silicon substrate 1, a paste mainly composed of silver was coated by screen printing in the shape of predetermined finger electrodes and bus bar electrodes. On the back surface, a paste mainly composed of aluminum was coated onto an entire surface by screen printing. Subsequently, thermal treatment (fire through) was performed at 850°C to form an electrode (first electrode 5 and second electrode 6), and BSF layer 4 was formed by allowing aluminum to diffuse in a portion of opening OA at the back surface. A photovoltaic cell element having a structure shown in Figure 4 was thus prepared.

In the aforementioned method, the silver electrode at the light receiving surface was formed by a fire through process without forming an opening in the SiN film. However, it is also possible to form a silver electrode by forming opening OA to the SiN film, and then forming the silver electrode.

For comparison, an aluminum paste was coated onto an entire back surface according to the above preparation process, except that passivation film 7 was not formed. Then, p⁺ layer 14 corresponding to BSF layer 4 and electrode 16 corresponding to second electrode were formed on the entire surface, thereby forming a photovoltaic cell element having a structure shown in Figure 1. With these photovoltaic cell elements, characterization (short-circuit current, open-voltage, fill factor, and conversion efficiency) was performed. The characterization was performed according to JIS-C-8913 (2005) and JIS-C-8914 (2005). The results are shown in Table 4.

From the results shown in Table 4, it was found that a photovoltaic cell element having passivation film 7 including niobium oxide and aluminum oxide exhibited an increased short-circuit current and an increased open voltage, as compared to a photovoltaic cell element not having passivation film 7, and that the conversion efficiency (incident photoelectric conversion efficiency) was increased by up to 1%, whereby it is revealed that the effects of the present invention are obtained.

**Table 4**

| Back Surface Passivation Film | Short-Circuit Current (mA/cm²) | Open Voltage (V) | Fill Factor | Conversion Efficiency (%) |
|---|---|---|---|---|
| a-1 | 33.5 | 0.635 | 0.804 | 17.0 |
| c-1 | 33.4 | 0.625 | 0.803 | 16.7 |
| None | 32.8 | 0.61 | 0.80 | 16.0 |

Although the inventions obtained by the present inventors are specifically explained based on embodiments and examples, the present invention is not limited by the embodiments and examples, which can be modified insofar as there is no departure from the gist of the invention.

The disclosures of Japanese Patent Application Publication No. 2012-160336 is incorporated herein by reference in their entirety. All literature, patent applications, and technical standards described in this specification are incorporated herein by reference to the same extent as if each individual item of literature, patent application and technical standard were specifically and individually indicated as being incorporated by reference.

## Claims

1. A passivation film comprising aluminum oxide and niobium oxide, wherein the passivation film is used in a photovoltaic cell element having a silicon substrate.

2. The passivation film according to claim 1, wherein a mass ratio of the niobium oxide to the aluminum oxide (niobium oxide/aluminum oxide) is from 30/70 to 90/10.

3. The passivation film according to claim 1 or 2, wherein a total content of the niobium oxide and the aluminum oxide is 90% by mass or more.

4. The passivation film according to any one of claims 1 to 3, further comprising an organic component.

5. The passivation film according to any one of claims 1 to 4, which is a thermally-treated product of a coating material comprising an aluminum oxide precursor and a niobium oxide precursor.

6. A coating material comprising an aluminum oxide precursor and a niobium oxide precursor, wherein the coating material is used for formation of a passivation film of a photovoltaic cell element having a silicon substrate.

7. A photovoltaic cell element, comprising:
a p-type silicon substrate that comprises monocrystalline silicon or polycrystalline silicon, and that has a light receiving surface and a back surface at an opposite side from the light receiving surface;
an n-type impurity diffusion layer that is formed on the light receiving surface of the silicon substrate;
a first electrode that is formed on a surface of the n-type impurity diffusion layer of the light receiving surface of the silicon substrate;
a passivation film that is formed on the back surface of the silicon substrate, the passivation film having plural openings and comprising aluminum oxide and niobium oxide; and
a second electrode that is electrically connected to the back surface of the silicon substrate through the plural openings.

8. A photovoltaic cell element, comprising:
a p-type silicon substrate that comprises monocrystalline silicon or polycrystalline silicon, and that has a light receiving surface and a back surface at an opposite side from the light receiving surface;
an n-type impurity diffusion layer that is formed on the light receiving surface of the silicon substrate;
a first electrode that is formed on a surface of the n-type impurity diffusion layer of the light receiving surface of the silicon substrate;
a p-type impurity diffusion layer that is formed on an entire or partial back surface of the silicon substrate, and that is doped with an impurity at a higher concentration than the silicon substrate;
a passivation film that is formed on the back surface of the silicon substrate, the passivation film having plural openings and including aluminum oxide and niobium oxide; and
a second electrode that is electrically connected to the p-type impurity diffusion layer of the back surface of the silicon substrate through the plural openings.

9. A photovoltaic cell element, comprising:
an n-type silicon substrate that comprises monocrystalline silicon or polycrystalline silicon and has a light receiving surface and a back surface at an opposite side from the light receiving surface;
a p-type impurity diffusion layer that is formed on the light receiving surface of the silicon substrate;
a second electrode that is formed on the back surface of the silicon substrate;
a passivation film that is formed on the light receiving surface of the silicon substrate, the passivation film having plural openings and including aluminum oxide and niobium oxide; and
a first electrode that is formed on the p-type impurity diffusion layer of the light receiving surface of the silicon substrate, and that forms an electrical connection with a surface at the light receiving side of the silicon substrate.

10. The photovoltaic cell element according to any one of claims 7 to 9, wherein a mass ratio of niobium oxide to aluminum oxide (niobium oxide/aluminum oxide) in the passivation film is from 30/70 to 90/10.

11. The photovoltaic cell element according to any one of claims 7 to 10, wherein a total content of the niobium oxide and the aluminum oxide in the passivation film is 90% by mass or more.

12. A silicon substrate having a passivation film, comprising:
a silicon substrate; and
the passivation film according to any one of claims 1 to 5, which is provided on an entire or partial surface of the silicon substrate.
